## Europäisches Patentamt
## European Patent Office
## Office européen des brevets

(19)

(11) Numéro de publication: **0 079 265 B1**

(12) **FASCICULE DE BREVET EUROPEEN**

(45) Date de publication du fascicule du brevet:
**27.12.85**

(51) Int. Cl.⁴: **H 01 L 23/14**, H 01 L 23/52

(21) Numéro de dépôt: **82401979.8**

(22) Date de dépôt: **26.10.82**

(54) **Procédé de réalisation d'un socle pour le montage d'une pastille semiconductrice sur l'embase d'un boîtier d'encapsulation.**

(30) Priorité: **06.11.81 FR 8120855**

(43) Date de publication de la demande:
**18.05.83 Bulletin 83/20**

(45) Mention de la délivrance du brevet:
**27.12.85 Bulletin 85/52**

(84) Etats contractants désignés:
**DE GB NL**

(56) Documents cités:
**FR - A - 1 483 563**
**FR - A - 2 012 333**
**GB - A - 2 046 514**
**GB - A - 2 047 466**

**IBM TECHNICAL DISCLOSURE BULLETIN, vol. 22, no. 8A, janvier 1980, pages 3421-3423, New York (USA); C.W.HO: "Lamination of silicon sheets for power buses"**

(73) Titulaire: **THOMSON-CSF, 173, Boulevard Haussmann, F-75379 Paris Cedex 08 (FR)**

(72) Inventeur: **Henry, Raymond, THOMSON-CSF SCPI 173, bld Haussmann, F-75379 Paris Cedex 08 (FR)**
Inventeur: **Resneau, Jean-Claude, THOMSON-CSF SCPI 173, bld Haussmann, F-75379 Paris Cedex 08 (FR)**

(74) Mandataire: **Taboureau, James et al, THOMSON-CSF SCPI 173, Bld Haussmann, F-75379 Paris Cedex 08 (FR)**

BUNDESDRUCKEREI BERLIN

**Description**

La présente invention concerne un procédé de réalisation d'un socle pour montage de pastilles de semiconducteurs, ce socle pouvant par exemple faire partie de l'embase d'un boîtier d'encapsulation. Elle s'applique plus particulièrement aux semiconducteurs travaillant à très haute fréquence et d'une manière générale au montage inversé, c'est-à-dire au montage où les électrodes sont réunies directement au puits thermique.

L'invention sera exposée en s'appuyant sur le cas non limitatif d'un transistor hyperfréquence comme exemple d'application, mais elle est valable dans d'autres cas de semiconducteurs, pour lesquels les phénomènes inductifs et thermiques sont importants.

En effet, le socle selon le procédé de l'invention a pour avantage principal de supprimer les fils ou rubans métalliques de liaison entre une pastille de semiconducteur et ses électrodes d'accès externe, ce qui supprime l'induction créée par ces fils. Par exemple, dans le cas d'un transistor hyperfréquence à effet de champ, l'induction ou self de source est très gênante car elle introduit une contre-réaction sortie-entrée.

Parmi les solutions connues pour supprimer cette self de source, l'une consiste à souder la pastille de semiconducteur à l'envers sur un socle céramique muni de métallisations en regard des métallisations de la pastille. Mais dans ce cas, pour sortir la connexion électrique d'une métallisation centrale, celle de source par exemple, il est nécessaire de passer sur la seconde face du socle céramique au moyen d'un trou métallisé. Une difficulté est de percer des trous par exemple rectangulaires, de 100 microns environ sur le petit côté, ceci dans une plaquette de céramique, d'alumine, d'oxyde de béryllium ou d'autres matériaux comparables. Une autre difficulté est d'avoir les plots de métallisations des trois électrodes (grille — source —drain) dans un même plan puisque la pastille rapportée a une surface plane.

Par contre, il est connu, par exemple du brevet GB-A-2 046 514, de réaliser des trous de petites dimensions dans des plaquettes de matériau semiconducteur ou non-semiconducteur monocristallin. A condition d'attaquer ce matériau selon certains plans cristallographiques déterminés, on sait attaquer chimiquement le silicium, par exemple, de façon anisotropique. Des solutions aqueuses contenant de l'eau oxygénée et de l'acide sulfurique, ou une attaque sèche par plasma réactif de fluorure de carbone CF4, permettent de percer des trous dans le silicium, avec une vitesse d'attaque selon une direction cristallographique beaucoup plus élevée que la vitesse d'attaque selon une seconde direction cristallographique orthogonale à la précédente. Cette sélectivité dans la direction d'attaque permet de réaliser des transistors, tels que celui décrit dans le document cité, dont les connexions sur les électrodes sont prises, à travers le substrat du transistor, par des trous métallisés. Cette technique de connexion est connue sous l'appellation anglaise de »via holes« et permet d'éviter l'emploi de file de liaison.

Le procédé selon l'invention apporte une solution à ces difficultés en remplaçant le socle céramique par un socle en matériau monocristallin, tel que le silicium ou les composés de la famille GaAs, par exemple, que l'on sait attaquer chimiquement avec une anisotropie si nécessaire, de façon à y percer des trous de très petites dimensions. Ainsi, selon l'invention, le difficile perçage mécanique d'un matériau polycristallin est remplacé par un perçage chimique d'un matériau monocristallin. De plus, la nécessité des plots métalliques dans le même plan reçoit une solution qui fait partie de l'invention.

Da façon plus précise, l'invention concerne un procédé de réalisation d'un socle pour le montage d'une pastille de semiconducteur, selon la technique de soudure inversée, la pastille de semiconducteur étant fixée sur le socle par l'intermédiaire d'au moins une métallisation d'électrode, en regard d'au moins une métallisation correspondante sur le socle, ledit socle comprenant au moins un perçage rempli d'un matériau conducteur faisant office de moyen de connexion, ce procédé étant caractérisé en ce qu'il comporte la suite des opérations suivantes:

— sur la plaquette de matériau monocristallin sensible à une attaque chimique anisotropique, de résistivité telle que $\rho \varepsilon \omega > 1$, et parfaitement plane, dépôt et gravure sur une première face des métallisations de report de la pastille de semiconducteur;

— dépôt et gravure d'un masque sur la seconde face de la plaquette, en vue de délimiter la zone de perçage chimique à l'aplomb d'au moins l'une des métallisations supportées par la première face de la plaquette;

— gravure d'au moins un perçage, sur toute l'épaisseur de la plaquette, par attaque chimique anisotropique par voie humide ou sèche, l'attaque chimique venant buter contre la métallisation précédemment déposée sur la première face de la plaquette;

— remplissage par voie électrolytique du perçage obtenu sous une métallisation par un métal bon conducteur thermique et électrique, la métallisation faisant fonction d'électrode pour le remplissage électrolytique du perçage.

L'invention sera mieux comprise par la description d'un exemple de réalisation, lequel s'appuie sur les figures jointes en annexe et représentant:

— figure 1: une vue partielle, en plan, du montage d'une pastille de semiconducteur dans son boîtier, selon l'art connu;

— figure 2: une vue en coupe d'un montage de semiconducteur sur son embase, selon une amélioration de l'art connu;
— figures 3 et 4: vues en coupe d'un montage de semiconducteur sur son embase, selon l'invention.

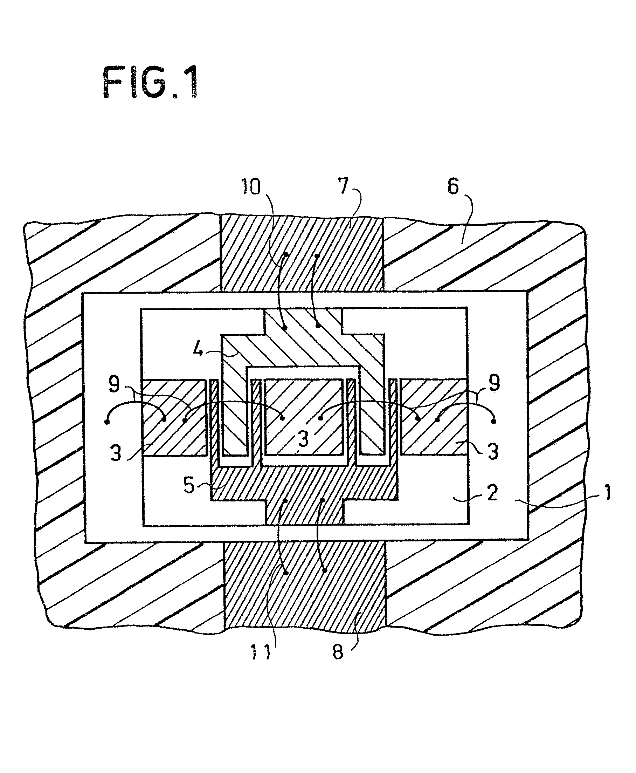

La figure 1 représente, vue en plan, la partie centrale d'un boîtier d'encapsulation comportant un semiconducteur, selon l'art connu.

Sur une embase métallique (1) est montée la pastille (2) d'un semiconducteur, brasé sur le métal de l'embase (1) soit directement, soit par l'intermédiaire d'un pavé d'oxyde de béryllium destiné à isoler de la masse mais aussi à adapter les coefficients de dilatation entre eux tout en ayant une bonne dissipation thermique. Sur la face libre de la pastille du semiconducteur (2) apparaissent les métallisations de prise de contact avec les différentes régions du semiconducteur. Puisque l'invention concerne essentiellement les semiconducteurs hyperfréquence et que l'exemple de réalisation s'appuie sur le cas d'un transistor, ces métallisations de prise de contact sont représentées par les métallisations (3) pour la source, (4) pour le drain et (5) pour la grille dans le cas d'un transistor à effet de champ. Dans le cas d'un transistor hyperfréquence, d'une part la métallisation de sourve est souvent divisée en plusieurs parties, et d'autre part la métallisation de grille est interdigitée avec les métallisations de source et de drain: dans le cas présent, la métallisation (3) de source est divisée en trois parties.

Autour de la pastille du semiconducteur (2), pour la protéger et l'encapsuler, se trouve un cadre céramique (6) dont seule la partie intéressante pour l'exposé est représentée. Ce cadre céramique supporte deux métallisations, ou plus exactement deux pattes métalliques (7) et (8) soudées sur la céramique qui constituent deux électrodes d'accès extérieur, à savoir grille et drain, la troisième électrode d'accès extérieur à savoir la source, étant le socle métallique (1).

Selon l'art connu, les métallisations à la surface de la pastille (2) sont réunies aux électrodes d'accès extérieur par l'intermédiaire de fils d'or ou d'aluminium thermo-comprimés. C'est ainsi que, à titre d'exemple, sur la figure (1), les électrodes de source sont réunies entre elles, puisqu'il y en a plusieurs, et à l'embase (1), par l'intermédiaire de fils métalliques (9). Les métallisations de drain (4) et de grille (5) sont réunies aux bandes métalliques (7) et (8) qui constituent les deux autres électrodes d'accès extérieur par l'intermédiaire, respectivement, d'un ou plusieurs fils métalliques, (10) pour le drain et (11) pour la grille.

L'existence de fils métalliques thermocomprimés à la surface d'une pastille, qui ne présente aux basses fréquences que des inconvénients de fiabilité mécanique, soudures mal faites ou arrachement possible, présente aux hautes et très hautes fréquences un autre inconvénient: celui de créer des selfs en série mais aussi entre électrodes. Ces selfs, notamment celle développée sur la source est très gênante car elle introduit une contre réaction entre l'entrée et la sortie du dispositif c'est-à-dire dans le cas présent entre source et grille.

Des solutions existent pour réduire ce phénomène de self parasite. Une première solution par exemple consiste à percer des trous dans les plots métalliques de source et à métalliser: la connexion de source se fait alors par l'intermédiaire de ces puits métallisés sur l'embase métallique (1), mais cette solution est difficile à mettre en œuvre en raison des dimensions extrêmement faibles des transistors hyperfréquence, qui obligent à percer des trous de l'ordre de 30 à 50 microns de diamètre.

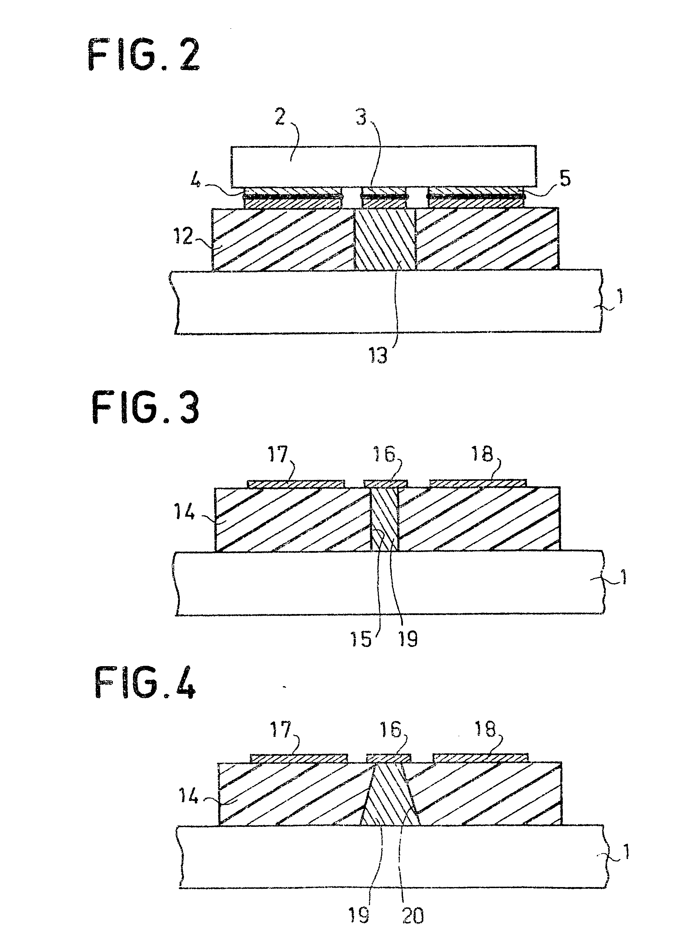

Une autre solution connue est représentée en figure 2: elle consiste à réaliser la soudure de la pastille inversée sur un support isolant.

Sur la figure 2, qui représente une vue en coupe d'un montage de semiconducteur sur son embase, les mêmes numéros de repère que sur la figure 1 ont été conservés de façon à simplifier les représentations. Sur une embase métallique (1) est montée une pastille de semiconducteur (2), mais celle-ci est soudée de manière dite inversée, c'est-à-dire que les métallisations des électrodes, qui étaient (3), (4) et (5) sur la figure 1, ne sont plus apparentes, extérieurement au dispositif mais ce sont elles qui sont soudées ou thermocomprimées sur d'autres métallisations portées par un socle isolant (12). Il y a donc un empilement: embase métallique (1) — socle isolant (12) — métallisation et soudure ou thermocompression entre métallisations (3), (4) et (5) — et enfin pastille de semiconducteur (2) inversée, c'est-à-dire que les zones actives du semiconducteur sont du côté du socle isolant (12). Les prises de contact peuvent se faire, par exemple sur la grille et le drain, sur les parties latérales débordantes des métallisations (4) et (5), et la prise de contact sur l'électrode centrale de source (3) se fait au moyen d'un trou (13) pratiqué dans le socle isolant (12) et rempli de métal, or, argent ou cuivre.

Ce genre de montage présente des avantages indéniables: quasi réduction à zéro de la self de source puisque les fils de connexion (9) sont supprimés, excellente dissipation thermique par l'intermédiaire des métallisations (3) et (13), en bon contact surfacique avec l'embase (1) et aussi par les métallisations (4) et (5) si le socle est en oxyde de béryllium. Par contre, ce procédé présente dans les cas connus un inconvénient assez important: le socle isolant (12) est réalisé en un matériau du genre céramique, polycristallin, c'est-à-dire qu'il est par exemple en alumine ou en oxyde de béryllium. Non seulement la surface de ce socle doit être parfaitement plane pour que les soudures sur les métallisations de source, drain et grille se fassent bien, mais de plus il est nécessaire de perforer ce socle (12) par au moins un trou ou une fente (13) correspondant à la prise de contact avec l'électrode centrale et les métallisations (3) et (13) sont difficilement obtenues avec (3) dans le même plan que (4) et (5). Compte tenu des dimensions très petites des métallisations sur les électrodes des transistors à très haute fréquence, il est nécessaire de percer un orifice (13) d'environ 100 microns dans sa plus petite dimensions à travers un socle d'alumine ou d'oxyde de béryllium d'approximativement 600 microns d'épaisseur. Cette difficulté technologique s'ajoute à la difficulté, qui demeure néanmoins, de la soudure d'une pastille inversée sur des métallisations très petites, devant être dans le même plan.

Le procédé selon l'invention reprend la configuration de structure de la figure 2, c'est-à-dire qu'il a recours à la soudure d'une pastille inversée, mais, selon ce procédé, le socle d'alumine ou d'oxyde de béryllium (12) est remplacé par un socle de silicium, d'arséniure de gallium ou d'un composé de la famille arséniure de gallium, ou, d'une manière plus générale, une matière de haute résistivité, monocristalline, que l'on sait attaquer chimiquement de façon anisotrope par la face arrière en vue de réaliser des trous ou des fentes de petites dimensions.

La figure 3 représente une vue en coupe d'un socle de montage de pastille de semiconducteur selon le procédé de l'invention.

De plus, les métallisations 17, 16 et 18 sont effectuées au préalable de sorte que le perçage chimique vient buter sur la métallisation (16) ce qui présente deux avantages:

— elles sont dans le même plan;
— (16) sert d'électrode pour le remplissage (19) par voie électrolytique.

Le socle (14) de dimensions égales ou légèrement supérieures aux dimensions de la pastille du semiconducteur est constitué par un matériau monocristallin et il supporte des métallisations (16), (17) et (18) qui correspondent, en dessin et en position, aux métallisations (3), (4) et (5) de la pastille qui doit y être fixée. De plus, ce socle comporte au moins un trou ou une fente (15) rempli par un métal (19) conducteur électrique et thermique. A titre d'exemple non limitatif, le trou ou le fente (15) peut avoir une profondeur de l'ordre de 600 microns, une largeur comprise entre 50 et 150 microns et une longueur de l'ordre de plusieurs centaines de microns. Le matériau monocristallin peut être comme il a été dit le silicium très résistif ou l'arséniure de gallium semi-isolant. Le silicium est particulièrement intéressant, outre son prix relativement modique, parce qu'il conduit bien la chaleur, avec un coefficient de conductivité égal à 0,2 calorie par seconde par centimètre, tandis que l'alumine a un coefficient de conductivité de 0,063, le cuivre étant pris égal à 1 arbitrairement. Par conséquent, le silicium améliore la dissipation thermique sur les plots de grilles et de drain par rapport à la céramique.

De plus, on sait attaquer le silicium monocristallin de façon fortement anisotropique, soit par un plasma réactif avec le fluorure de carbone CF4, soit chimiquement en choisissant les plans cristallins de façon adéquate: à ce titre, voir par exemple l'article »The Etching of deep Vertical Walled patterns in Silicon« de A. I. Stoller dans RCA Review de Juin 1970. Ces procédés permettent une attaque verticale environ 25 fois plus rapide que l'attaque latérale; ils permettent par conséquent de procéder à une perforation profonde d'une plaque de silicium en limitant la surface d'attaque.

Dans le cas non limitatif du silicium, celui-ci doit être de haute résistivité, c'est-à-dire par exemple 4000 ohms par centimètre ou plus. Il suffit que $\rho\varepsilon\omega \gg 1$, avec $\rho$ = résistivité du silicium, $\varepsilon$ = constante diélectrique du silicium, $\omega$ = pulsation, cést-à-dire $\frac{\omega}{2\pi}$ = fréquence d'utilisation comprise par exemple entre quelques gigahertz et 20 gigahertz.

Les métallisations sur la face dite avant du socle de silicium, c'est-à-dire les métallisations (16), (17) et (18) qui servent à souder par soudure inversée la pastille du semiconducteur, sont évidemment des métallisations localisées réalisées par exemple par la chaîne SiPt—TiPt—Or: elles sont déposées avant l'attaque anisotropique du matériau constituant le socle.

La face arrière du socle de silicium (14), c'est-à-dire la face opposée à celle qui porte les métallisations (16), (17) et (18) est ensuite masquée, et photogravée en vue de percer le trou ou la fente (15). On attaque les sillons à l'aplomb de la métallisation centrale, c'est-à-dire la métallisation (16) dans le cas de figure. Il a été dit que l'attaque verticale est 25 fois plus rapide que l'attaque latérale, et selon le procédé mis en œuvre pour percer ce socle de silicium, c'est-à-dire plasma réactif ou attaque chimique, on obtient soit un perçage dont les parois sont parallèles entre elles comme le perçage représenté en (15) sur la figure 3, soit un perçage cônique comme le perçage représenté en (20) sur la figure 4. L'attaque du socle de silicium (14) s'arrête contre la métallisation (16) qui ne subit pas le perçage que subit le silicium.

Il est alors nécessaire pour obtenir une connexion à travers le socle de silicium de remplir le trou ou la fente (15) ou (20) par un métal conducteur (19) tel que l'argent ou le cuivre. Etant donné que la réalisation de socles de silicium (14) se fait selon une méthode collective sur plaquettes, il est facile de réaliser des métallisations telles que (16) qui, à l'origine, sont toutes réunies entre elles et sont de plus réunies à une couronne métallique portée à la périphérie de la rondelle de silicium. En réunissant cette couronne périphérique à une source de potentiel, on facilite le dépôt électrique et le remplissage des trous (15) ou (20) par un métal (19).

Etant donné que la métallisation (16) qui correspond au perçage (15) a été réalisée à l'origine coplanaire avec les autres métallisations (17 et 18) de report de la pastille, elle est encore coplanaire après le remplissage du trou (15), sans qu'il soit nécessaire de recourir à un polissage de surface.

Les rondelles de fabrication collective des socles sont ensuite découpées, chaque socle élémentaire est éventuellement métallisé sur sa face arrière, puis soudé sur une embase métallique (1), et la pastille de semiconducteur est soudée ou thermocomprimée à l'envers sur le socle monocristallin.

Aux épaisseurs considérées, le matériau du semiconducteur (2) est opaque à la lumière visible mais est transparent aux infrarouges: par conséquent, si on le désire une illumination en infrarouges peut permettre que les métallisations (3), (4) et (5) de la pastille de semiconducteur (2) soient repérées par rapport aux métallisations (16), (17) et (18) du socle et soudées en bonne position, mais il existe d'autres solutions connues de repérage précis.

L'invention a été décrite en prenant un exemple d'application qui est un transistor hyperfréquence et en citant le silicium. De plus, étant donné que dans un transistor hyperfréquence, la source est généralement située entre grille et drain, c'est l'électrode de source qui est reliée au socle métallique. Ces exemples ne présentent pas un caractère limitatif de l'invention qui s'applique à d'autres composants que les transistors à effet de champ, par exemple transistors bipolaires ou diodes, ainsi qu'au socle isolant qui peut être en d'autres matériaux que le silicium pourvu que l'on sache attaquer ce matériau de façon anisotrope et venir buter sur la métallisation. Enfin, selon le cas de figure, il peut être intéressant de réaliser la connexion sur le socle non plus à partir de la source mais par exemple à partir du drain ou de la grille pour mettre cette électrode à la masse électrique.

D'une façon plus générale, l'invention ne saurait être limitée par la description de l'exemple qui en a été donnée, et elle est précisée par les revendications suivantes, auxquelle l'homme de l'art peut apporter des variantes sans sortir du domaine de l'invention.

## Revendications

1. Procédé de réalisation d'un socle pour le montage d'une pastille semiconductrice (2), selon la technique de soudure inversée, la pastille de semiconducteur étant fixée sur le socle par l'intermédiaire d'au moins une métallisation (3, 4, 5) d'électrode, en regard d'au moins une métallisation correspondante (16, 17, 18) sur le socle, ledit socle (14) comprenant au moins un perçage (15) rempli d'un matériau (19) conducteur faisant office de moyen de connexion, ce procédé étant caractérisé en ce qu'il comporte la suite des opérations suivantes:

— sur une plaquette de matériau monocristallin (14) sensible à une attaque chimique anisotropique, de résistivité telle que $\rho\varepsilon\omega \gg 1 =$ $\rho$ étant la résistivité du matériau, $\varepsilon$ sa constante diélectrique et $\omega$ la pulsation de

fonctionnement, et parfaitement plane, dépôt et gravure sur une première face des métallisations (16, 17, 18) de report de la pastille de semiconducteur;

— dépôt et gravure d'un masque sur la seconde face de la plaquette, en vue de délimiter la zone de perçage chimique à l'aplomb d'au moins l'une (16) des métallisations supportées par la première face de la plaquette;

— gravure d'au moins un perçage (15), sur toute l'épaisseur de la plaquette, par attaque chimique anisotropique par voie humide ou sèche, l'attaque chimique venant buter contre la métallisation (16) précédemment déposée sur la première face de la plaquette;

— remplissage par voie électrolytique du perçage (15) obtenu sous une métallisation (16) par un métal (19) bon conducteur thermique et électrique, la métallisation (16) faisant fonction d'électrode pour le remplissage électrolytique du perçage.

2. Procédé de réalisation d'un socle selon la revendication 1, caractérisé en ce que le matériau du socle (14) est un matériau semiconducteur, choisi parmi les composés des familles IV et III-V.

3. Procédé de réalisation d'un socle selon la revendication 1, caractérisé en ce que le moyen de gravure d'au moins un perçage (15) est une solution chimique aqueuse, appropriée à l'attaque anisotropique du matériau constituant le socle (14).

4. Procédé de réalisation d'un socle selon la revendication 1, caractérisé en ce que le moyen de gravure d'au moins un perçage (15) est un plasma réactif sec de fluorure de carbone CF4.

5. Procédé de réalisation d'un socle selon la revendication 1, caractérisé en ce que le remplissage électrolytique du passage (15) se fait au cours d'une opération collective, toutes les métallisations (16) des socles (14) compris dans une même rondelle de matériau monocristallin étant réunies à une couronne métallique portée par le périphérie de la rondelle, qui sert d'électrode pour le remplissage des perçages par un métal (19).

## Patentansprüche

1. Verfahren zur Herstellung eines Sockels zum Anbringen eines Halbleiterplättchens (2) nach der Technik der invertierten Lötung, wobei das Halbleiterplättchen auf dem Sockel über wenigstens eine Elektrodenmetallisierung (3, 4, 5) gegenüber wenigstens einer entsprechenden Metallisierung (16, 17, 18) auf dem Sockel befestigt ist und der Sockel (14) wenigstens einen Durchbruch (15) aufweist, welcher mit einem leitfähigen Material (19) ausgefüllt ist, das als Verbindungsmittel dient, wobei das Verfahren dadurch gekennzeichnet ist, daß es die Aufeinanderfolge der folgenden Arbeitsschritte umfaßt:

— auf einem Plättchen aus monokristallinem Material (14), das anisotrop chemisch angreifbar ist und einen solchen spezifischen Widerstand aufweist, daß $\rho\varepsilon\omega \gg 1$ ist, worin $\rho$ der spezifische Widerstand des Materials, $\varepsilon$ seine Dielektrizitätskonstante und $\omega$ die Betriebs-Kreisfrequenz ist, und welches vollkommen eben ist, werden auf einer ersten Fläche Metallisierungen (16, 17, 18) für das Aufsetzen des Halbleiterplättchens aufgebracht und graviert;

— auf der zweiten Fläche der Scheibe wird eine Maske abgelagert und graviert, um die Zone des auf chemischem Wege herzustellenden Durchbruchs senkrecht unter wenigstens einer der Metallisierungen (16) zu begrenzen, welche die erste Fläche der Scheibe trägt;

— Gravieren wenigstens eines Durchbruchs (15) über die gesamte Dicke der Scheibe durch anisotropes chemisches Angreifen auf feuchtem oder trockenem Wege, wobei der chemische Angriff auf die Metallisierung (16) trifft, welche zuvor auf der ersten Fläche der Scheibe abgelagert wurde;

— Ausfüllen des unter einer Metallisierung erhaltenen Durchbruchs (15) auf elektrolytischem Wege mit einem Metall (19), das elektrisch und thermisch gut leitfähig ist, wobei die Metallisierung (16) als Elektrode zum elektrolytischen Ausfüllen des Durchbruchs wirksam ist.

2. Verfahren zur Herstellung eines Sockels nach Anspruch 1, dadurch gekennzeichnet, daß das Material des Sockels (14) ein Halbleitermaterial ist, welches aus den Verbindungen der Familien IV und III-V ausgewählt ist.

3. Verfahren zur Herstellung eines Sockels nach Anspruch 1, dadurch gekennzeichnet, daß das Mittel zum Gravieren wenigstens eines Durchbruchs (15) eine wäßrige chemische Lösung ist, die geeignet zum anisotropen Angriff des Materials ist, aus welchem der Sockel (14) gebildet ist.

4. Verfahren zur Herstellung eines Sockels nach Anspruch 1, dadurch gekennzeichnet, daß das Mittel zum Gravieren wenigstens eines Durchbruchs (15) ein trockenes reaktives Plasma aus Kohlenstofffluorid CF4 ist.

5. Verfahren zur Herstellung eines Sockels nach Anspruch 1, dadurch gekennzeichnet, daß das elektrolytische Ausfüllen des Durchbruchs (15) im Verlauf eines Sammel-Arbeitsschrittes erfolgt, wobei sämtliche Metallisierungen (16) der Sockel (14), die in derselben Rundscheibe aus monokristallinem Material enthalten sind, mit einem metallischen Kranz verbunden sind, den der Umfang der Rundscheibe trägt und der als Elektrode zum Auffüllen der Durchbrüche mit einem Metall (19) dient.

## Claims

1. Method of producing a base for the mounting of a semiconductor chip (2) in accordance with the technique of inverted soldering, the semiconductor chip being fixed on the base through at least one electrode metallization (3, 4, 5) facing at least one corresponding metallization (16, 17, 18) on the base, said base (14) comprising at least one opening (15) filled with a conductive material (19) forming a connection means, the method being characterized in that it comprises the sequence of the following operations:

— on a sheet of monocrystalline material (14) which is sensitive to an anisotropic chemical attack and having a resistivity such that $\rho\varepsilon\omega \gg 1$ wherein $\rho$ is the resistivity of the material, $\varepsilon$ its dielectric constant and $\omega$ being the operating angular frequency, and which is perfectly plane, metallizations (16, 17, 18) for the positioning of the semiconductor chip are deposited and engraved on a first face;

— a mask is deposited and engraved on the second face of the sheet in order to define the zone of chemical attack vertically beneath at least one (16) of the metallizations carried by the first face of the sheet;

— engraving at least one opening (15) through the entire thickness of the sheet by anisotropic chemical attack in a humid or dry environment, the chemical attack abutting against the metallization (16) previously deposited on the first face of the sheet;

— electrolytic filling of the opening (15) obtained beneath one metallization (16) with a metal (19) of good thermal and electrical conductivity, the metallization (16) acting as an electrode for the electrolytic filling of the opening.

2. Method of producing a base according to claim 1, characterized in that the material of the base (14) is a semiconductor material selected among the compositions of the groups IV and III-V.

3. Method of producing a base according to claim 1, characterized in that the means for engraving of at least one opening (15) is an aqueous chemical solution appropriate for the anisotropic attack of the material forming the base (14).

4. Method of forming a base according to claim 1, characterized in that the means for engraving at least one opening (15) is a dry reactive plasma of carbon fluoride CF4.

5. Method of producing a base according to claim 1, characterized in that the electrolytic filling of the passage (15) is made in the course of a collective operation, all of the metallizations (16) of the bases (14) comprised in the same disc of monocrystalline material being connected to a metallic collar carried by the periphery of the disc and used as an electrode for the filling of the openings with a metal (19).

FIG.1

# FIG. 2

# FIG. 3

# FIG. 4